# EUROPÄISCHE PATENTSCHRIFT

(11) **EP 2 426 789 B1**
(45) Veröffentlichungstag und Bekanntmachung des Hinweises auf die Patenterteilung: **25.06.2014**
(21) Anmeldenummer: 11176848.7
(22) Anmeldetag: 08.08.2011
(51) Int. Cl.: H01R 13/506, H01R 13/24, H01L 25/07, H01R 13/52, H01R 11/18

(54) **Anschlusseinrichtung für ein Leistungshalbleitermodul**
Connection device for a semiconductor module
Dispositif de connexion pour un module semi-conducteur de puissance

(30) Priorität: 01.09.2010 DE 102010035980
(43) Veröffentlichungstag der Anmeldung: 07.03.2012
(73) Patentinhaber: Semikron Elektronik GmbH & Co. KG Patentabteilung, 90431 Nürnberg (DE)
(72) Erfinder: Lederer, Marco, 90453 Nürnberg (DE); Popp, Rainer, 91580 Petersaurach (DE)

(56) Entgegenhaltungen:
- DE-A1-102006 006 421
- DE-A1-102006 058 694
- US-A- 3 541 360

## Beschreibung

Die Erfindung betrifft eine Anschlusseinrichtung für ein Leistungshalbleitermodul, das ein Gehäuse für mindestens ein Schaltungssubstrat und einen Druckkörper zur Druckkontaktierung mindestens eines Anschlusselementes aufweist, das als Kontaktfeder mit einem ersten Kontaktteil und einem zweiten Kontaktteil und einem Federabschnitt zwischen dem ersten und dem zweiten Kontaktteil ausgebildet ist.

Aus der DE 102006006421 A1 ist ein Leistungshalbleitermodul mit mindestens einem Schaltungssubstrat, mindestens einem hierauf angeordneten Leistungshalbleiterbauelement, einem Gehäuse, einem ersten und einem zweiten Kunststoffformkörper und nach außen führenden Anschlusselementen bekannt, wobei das Substrat einen Isolierstoffkörper aufweist, auf dessen dem Inneren des Leistungshalbleitermoduls zugewandten Hauptfläche Leiterbahnen vorgesehen sind, und wobei mindestens ein Anschlusselement als eine Kontaktfeder mit einem ersten Kontaktteil und einem zweiten Kontaktteil und einem Federabschnitt zwischen dem ersten und dem zweiten Kontaktteil ausgebildet ist.

Aus der DE 10 2006 006 421 A1 ist ein Leistungshalbleitermodul mit mindestens einem Substrat, mindestens einem hierauf angeordnete Leistungshalbleiterbauelement, einem Gehäuse, einem ersten Kunststoffformkörper, nach außen führenden Anschlusselementen und einem zweiten Kunststoffformkörper, wobei das Substrat einen lsolierstoffkörper aufweist, bekannt.

Aus der DE 10 2006 058 694 A1 ist ein Leistungshalbleitermodul mit einem Gehäuse, einem Substrat mit mindestens einer metallischen Leiterbahn, und mindestens einem von einer Leiterbahn oder einer Kontaktfläche eines auf einer Leiterbahn angeordneten Leistungshalbleiterbauelements nach außen führenden Anschlusselementen bekannt, wobei mindestens ein Anschlusselement als Kontaktfeder mit einer ersten Kontakteinrichtung, einem federnden Abschnitt und einer zweiten Kontakteinrichtung ausgebildet ist.

Aus der US 3 541 360 A ist ein Einrichtung zur Einwirkung auf ein Piezoelement bekannt.

Bei einem solchen bekannten Leistungshalbleitermodul ist jedoch insbesondere nach einer sehr langen Einsatz - d. h. Lebensdauer durch das mindestens eine Anschlusselement eine unerwünschte Kunststoffkorrosion nicht zuverlässig ausschließbar.

In Kenntnis dieser Gegebenheiten liegt der Erfindung die Aufgabe zugrunde, eine Anschlusseinrichtung für ein Leistungshalbleitermodul zu schaffen, wobei eine Kunststoffkorrosion zuverlässig ausschließbar ist.

Diese Aufgabe wird erfindungsgemäß durch die Merkmale des Anspruches 1 gelöst.

Erfindungsgemäß kann das Gehäuse und/oder der Druckkörper aus jedem beliebigen geeigneten Kunststoffmaterial bestehen, wobei eine Kunststoffkorrosion vermieden wird, weil der erste und der zweite Federschachtkörper, welche den Federschacht bilden, aus einem gegen eine Kunststoffkorrosion resistenten Kunststoffmaterial bestehen.

Weitere Vorteile der erfindungsgemäßen Anschlusseinrichtung bestehen darin, dass der Federschacht vom Gehäuse und vom Druckkörper unabhängig vormontiert ist und der vormontierte Federschacht vorab geprüft werden kann. Weitere Vorteile der erfindungsgemäßen Anschlusseinrichtung bestehen darin, dass der erste und der zweite Federschachtkörper mit einfachen Formwerkzeugen kostengünstig herstellbar sind, wobei auch genauere mechanische Abmessungstoleranzen realisierbar sind, und dass der jeweilige aus dem ersten und dem zweiten Federschachtkörper bestehende Federschacht einfach montiert werden kann.

Bei der erfindungsgemäßen Anschlusseinrichtung hat es sich als zweckmäßig erwiesen, wenn das erste Kontaktteil der Kontaktfeder dem ersten Federschachtkörper und das zweite Kontaktteil den zweiten Federschachtkörper zugeordnet ist. Bevorzugt ist es hierbei, wenn der erste und der zweite Federschachtkörper gegen Verdrehung gesichert zum jeweiligen Federschacht verbunden sind.

Um die Axialbeweglichkeit zwischen dem ersten und dem zweiten Federschachtkörper definiert zu begrenzen, weist der erste Federschachtkörper mindestens ein federndes Rastorgan und der zweite Federschachtkörper mindestens ein Langloch auf, in das das federnde Rastorgan des ersten Federschachtkörpers federnd hineinsteht.

Als zweckmäßig hat es sich erwiesen, wenn der erste Federschachtkörper eine an einer Anschlag-Öffnung im Gehäuse anliegende Anlageschulter aufweist. Mit dieser Anlageschulter ist der erste Federschachtkörper in Bezug zum Gehäuse im zusammengebauten Zustand des Leistungshalbleitermoduls an der Anschlag-Öffnung definiert unbeweglich festgelegt. Der zweite Federschachtkörper ist vorzugsweise mit einem Widerlagerbund für den Druckkörper ausgebildet, so dass der zweite Federschachtkörper in Bezug zum ersten Federschachtkörper mit Hilfe des Druckkörpers axial begrenzt bewegbar ist, um die im entsprechenden Federschacht vorgesehene Kontaktfeder von einem inaktiven Lagerzustand in ihren aktiven Kontaktzustand zu bringen. Zweckmäßig ist es, wenn der zweite Federschachtkörper im Druckkörper verdrehfest vorgesehen ist.

Der zweite Federschachtkörper steht vorzugsweise mit einem Kappenabschnitt aus dem Druckkörper vor. Der Kappenabschnitt des zweiten Federschachtkörpers ist oberseitig vorzugsweise mit einem Querschlitz ausgebildet, aus dem das zweite Kontaktteil der Kontaktfeder U-förmig gebogen vorsteht. Das zweite Kontaktteil der Kontaktfeder ist beispielsweise zur Kontaktierung mit einer Steuerungsplatine oder dergleichen vorgesehen.

Der erste Federschachtkörper des jeweiligen Federschachtes weist unterseitig ein Durchgangsloch für das erste Kontaktteil der Kontaktfeder auf, das vorzugsweise geradlinig stiftförmig ausgebildet ist.

Wie bereits erwähnt worden ist, bestehen der erste und der zweite Federschachtkörper des Federschachtes vorzugsweise aus einem korrosionsfesten Kunststoffmaterial, so dass die Einsatz - d. h. Lebensdauer eines mit erfindungsgemäßen Anschlusseinrichtungen versehenen Leistungshalbleitermoduls durch Kunststoffkorrosion nicht beeinträchtigt wird.

Erfindungsgemäß können mindestens zwei Federschächte mit den zugehörigen Kontaktfedern integral zu einem Federschachtblock kombiniert sein. Hierdurch ist der Montageaufwand bei der Kombination eines Leistungshalbleitermoduls mit erfindungsgemäßen Anschlusseinrichtungen entsprechend reduziert.

Weitere Einzelheiten, Merkmale und Vorteile ergeben sich aus der nachfolgenden Beschreibung der Erfindung in Verbindung mit den anliegenden Zeichnungen.

Es zeigen:
- Fig. 1: eine perspektivische Ansicht einer Ausführungsform der erfindungsgemäßen Anschlusseinrichtung für ein Leistungshalbleitermodul im inaktiven Lagerzustand, d. h. im nicht mittels eines Druckkörpers beaufschlagten Zustand,
- Fig. 2: eine perspektivische Ansicht der Anschlusseinrichtung gemäß Figur 1 im aktiven, d. h. mittels eines Druckkörpers beaufschlagten Kontaktierzustand,
- Fig. 3: eine der Figur 1 prinzipiell ähnliche Darstellung der Anschlusseinrichtung sowie eines abschnittweise gezeichneten Druckkörpers und eines ebenfalls abschnittweise gezeichneten Gehäuses eines Leistungshalbleitermoduls,
- Fig. 4: eine der Figur 2 prinzipiell ähnliche Darstellung der Anschlusseinrichtung mit dem gegen das abschnittweise gezeichneten Gehäuse des Leistungshalbleitermoduls bewegten, abschnittweise gezeichneten Druckkörper,
- Fig. 5: eine perspektivische Ansicht eines entlang von Anschlusseinrichtungen aufgeschnittenen Druckkörpers mit zugehörigen Anschlusseinrichtungen, und
- Fig. 6: einen Schnitt durch ein Leistungshalbleitermodul mit einem Gehäuse für ein Schaltungssubstrat, einem Druckkörper und mit Anschlusseinrichtungen.

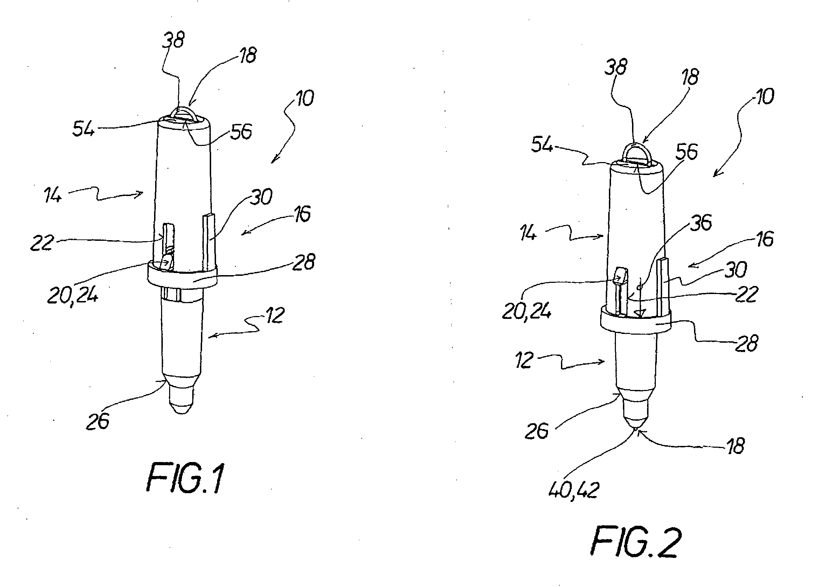

Figur 1 zeigt eine Ausbildung der Anschlusseinrichtung 10 für ein Leistungshalbleitermodul. Die Anschlusseinrichtung 10 weist einen ersten Federschachtkörper 12 und einen zweiten Federschachtkörper 14 auf, die miteinander axial fluchtend zu einem Federschacht 16 für eine Kontaktfeder 18 verbunden sind.

Der erste Federschachtkörper 12 ist mit einem Paar des sich diametral gegenüberliegenden federnden Rastorganen 20 und der zweite Federschachtkörper 14 ist mit diametral gegenüberliegenden Langlöchern 22 ausgebildet. Jedes federnde Rastorgan 20 ist an seinem distalen Ende mit einem Rasthaken 24 ausgebildet, der in das zugehörige Langloch 22 des zweiten Federschachtkörpers 14 hineinsteht.

Durch die Langlöcher 22 im zweiten Federschachtkörper 14 ist die relative Beweglichkeit des ersten und zweiten Federschachtkörper 12 und 14 in axialer Richtung definiert begrenzt. Außerdem ergibt sich hierdurch eine verdrehfeste Verbindung des ersten und zweiten Schachtkörpers 12 und 14 zum Federschacht 16.

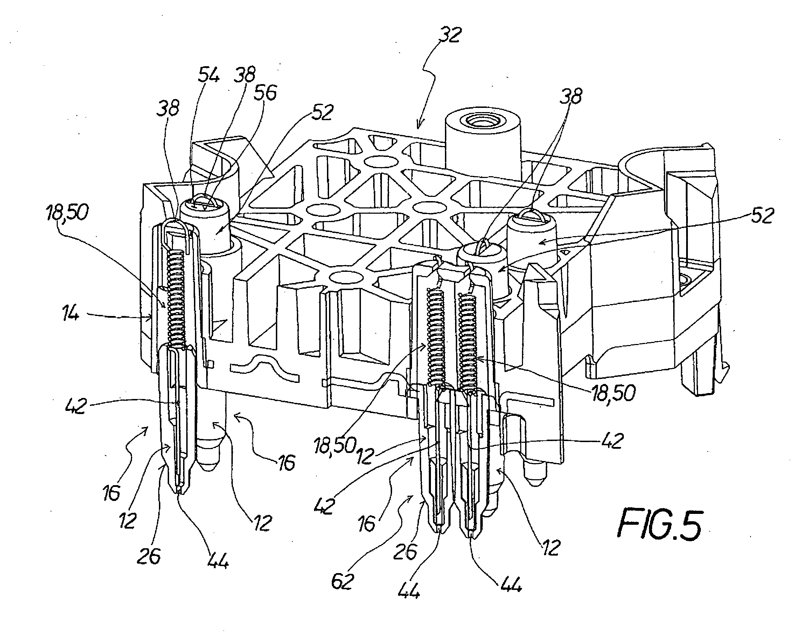

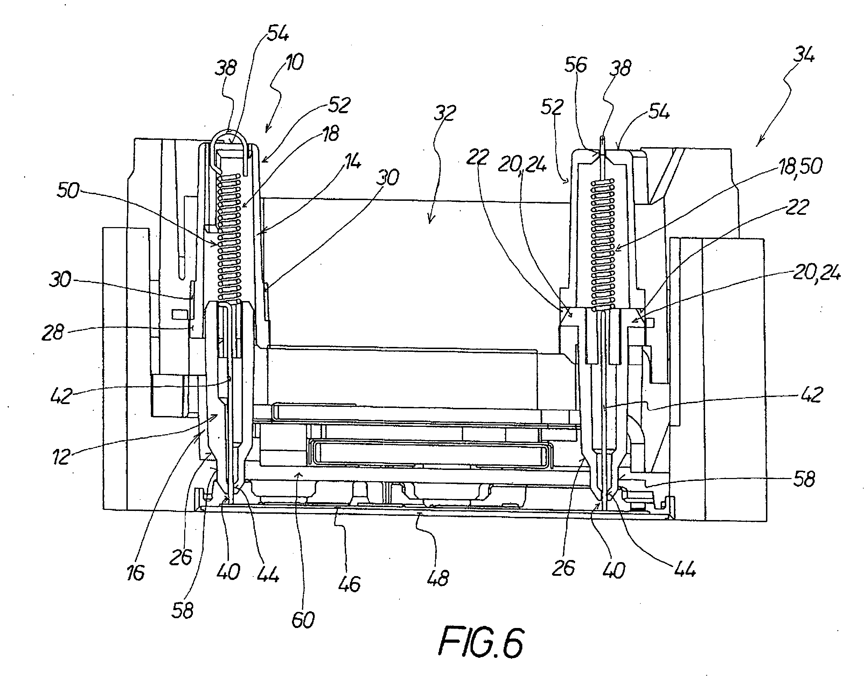

Der erste Federschachtkörper 12 ist an seinem vom zweiten Federschachtkörper 14 abgewandten Endabschnitt mit einer Anlageschulter 26 ausgebildet. Der zweite Federschachtkörper 14 ist an seinem dem ersten Federschachtkörper 12 zugewandten Endabschnitt mit einem Widerlagerbund 28 ausgebildet. Vom Widerlagerbund 28 des zweiten Federschachtkörper 14 stehen axial, diametral gegenüberliegende Rippen 30 materialeinstückig weg. Die Rippen 30 bewirken eine Verdrehsicherung des Federschachtes 16 in Bezug zu einem Druckkörper 32 eines Leistungshalbleitermoduls 34 (siehe die Figuren 5 und 6).

In Figur 2 sind gleiche Einzelheiten mit denselben Bezugsziffern wie in Figur 1 bezeichnet, sodass es sich erübrigt, in Verbindung mit Figur 2 alle Einzelheiten noch einmal detailliert zu beschreiben. In Figur 2 ist der Federschacht 16 im aktiven Kontaktzustand der Kontaktfeder 18 gezeichnet. Dieser aktive Kontaktzustand wird mit Hilfe des Druckkörpers 32 des Leistungshalbleitermoduls 34 erreicht, indem der Druckkörper 32 gegen den Widerlagerbund 28 des zweiten Federschachtkörpers 14 wirksam ist. Das ist in Figur 2 durch den Pfeil 36 angedeutet.

Im aktiven Kontaktzustand ragt die Kontaktfeder 18 mit einem U-förmig gebogenen zweiten Kontaktteil 38 weiter aus dem zweiten Federschachtkörper 14 heraus als im in Figur 1 gezeichneten inaktiven Zustand. Gleichzeitig steht ein distales Ende 40 eines ersten Kontaktteiles 42 der Kontaktfeder 18 aus einem Durchgangsloch 44 (siehe die Figuren 5 und 6) vor, um die Kontaktfeder 18 mit einer strukturierten Metallisierung 46 zu kontaktieren, die an einem Schaltungssubstrat 48 des Leistungshalbleitermoduls 34 vorgesehen ist.

Die Figuren 5 und 6 verdeutlichen außerdem einen Federabschnitt 50 der jeweiligen Kontaktfeder 18 zwischen dem geradlinig stiftförmigen ersten Kontaktteil 42 und dem davon abgewandten U-förmig gebogenen zweiten Kontaktteil 38 der jeweiligen Kontaktfeder 18. Der Federabschnitt 50 ist als Schraubendruckfeder gestaltet.

Wie aus Figur 6 ersichtlich ist, ist das stiftförmige erste Kontaktteil 42 der jeweiligen Kontaktfeder 18 dem ersten Federschachtkörper 12 und das zweite Kontaktteil 38 mit dem Federabschnitt 50 dem zweiten Federschachtkörper 14 des jeweiligen Federschachtes 16 zugeordnet. Außerdem verdeutlichen diese Figuren, dass der jeweilige zweite Federschachtkörper 14 mit einem Kappenabschnitt 52 aus dem Druckkörper 32 vorsteht. Aus den Figuren 1 bis 4 ist ersichtlich, dass der Kappenabschnitt 52 des zweiten Federschachtkörpers 14 an seiner Oberseite 54 mit einem Querschlitz 56 ausgebildet ist, aus welchem das U-förmig gebogene zweite Kontaktteil 38 der Kontaktfeder 18 vorsteht, so dass sich im Federschacht 16 eine Sicherung der Kontaktfeder 18 gegen Verdrehung ergibt.

Aus Figur 6 ist des weiteren ersichtlich, dass der erste Federschachtkörper 12 des jeweiligen Federschachtes 16 mit seiner Anlageschulter 26 an einer Anschlag-Öffnung 58 anliegt, die in einem Gehäuse 60 des Leistungshalbleitermoduls 34 ausgebildet ist, so dass der erste Federschachtkörper 12 in Bezug zum Gehäuse 60 axial unbeweglich ist.

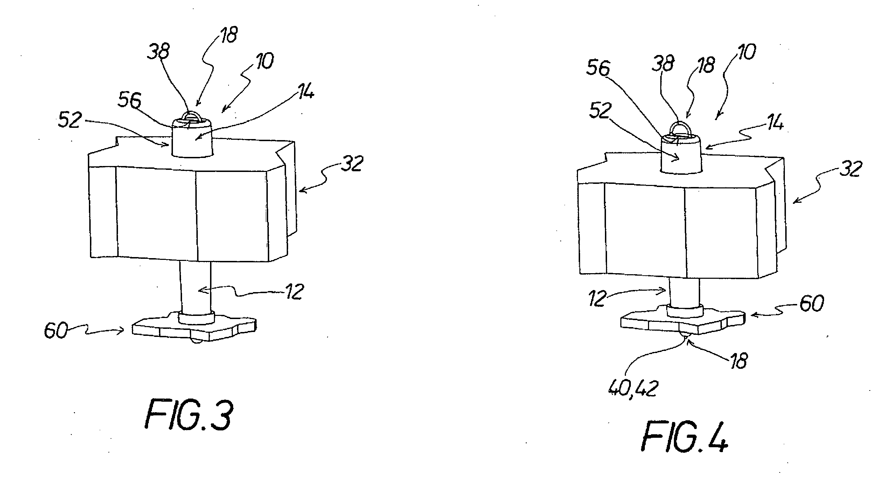

Die Figuren 3 und 4 verdeutlichen schematisch abgeschnitten den Druckkörper 32 und das Gehäuse 60 sowie einen Federschacht 16, wie sie oben in Verbindung mit den übrigen Figuren detailliert beschrieben worden sind.

Gleiche Einzelheiten sind in den Figuren 1 bis 6 jeweils mit denselben Bezugsziffern bezeichnet, so dass es sich erübrigt, in Verbindung mit allen Figuren alle Einzelheiten jeweils detailliert zu beschreiben, wobei die Figur 5 nicht nur einzelne Federschächte 16 sondern außerdem auch einen Federschachtblock 62 verdeutlicht, bei welchem zwei Federschächte 16 miteinander integral kombiniert sind.

### Bezugszeichenliste

- 10: Anschlusseinrichtung
- 12: erster Federschachtkörper (von 10)
- 14: zweiter Federschachtkörper (von 10)
- 16: Federschacht (von 10)
- 18: Kontaktfeder (von 10 in 16)
- 20: federndes Rastorgan (an 12)
- 22: Langloch (in 14 für 20)
- 24: Rasthaken (an 20)
- 26: Anlageschulter (von 12 für 32)
- 28: Widerlagerbund (von 14)
- 30: Rippe (an 14)
- 32: Druckkörper (von 34)
- 34: Leistungshalbleitermodul
- 36: Pfeil (bei 28)
- 38: zweites Kontaktteil (von 18)
- 40: distales Ende (von 42)
- 42: erstes Kontaktteil (von 18)
- 44: Durchgangsloch (in 12 für 42)
- 46: strukturierte Metallisierung (an 48)
- 48: Schaltungssubstrat (von 34)
- 50: Federabschnitt (von 18)
- 52: Kappenabschnitt 8von 14)
- 54: Oberseite (von 52)
- 56: Querschlitz (an 54 für 38)
- 58: Anschlag-Öffnung (in 60 für 12)
- 60: Gehäuse (von 34)
- 62: Federschachtblock (von 10)

## Patentansprüche

1. Anschlusseinrichtung für ein Leistungshalbleitermodul (34), das ein Gehäuse (60) für mindestens ein Schaltungssubstrat (48) und einen Druckkörper (32) zur Druckkontaktierung eines Anschlusselementes aufweist, das als Kontaktfeder (18) mit einem ersten Kontaktteil (42) und einem zweiten Kontaktteil (38) und einem Federabschnitt (50) zwischen dem ersten und dem zweiten Kontaktteil (42, 38) ausgebildet ist,
**dadurch gekennzeichnet,**
**dass** die Anschlusseinrichiung (10) einen dem Gehäuse (60) zugeordneten ersten Federschachtkörper (12) und einen den Druckkörper (32) zugeordneten zweiten Federschachtkörper (14) aufweist, die miteinander axial fluchtend zu einem Federschacht (16) verbunden und gegeneinander axial begrenzt beweglich sind, wobei der Federschacht (16) vom Gehäuse (60) und vom Druckkörper (32) unabhängig vormontierbar ist, wobei die Kontaktfeder (18) im Federschacht (16) unverlierbar vorgesehen ist, wobei der erste Federschachtkörper (12) mindestens ein federndes Rastorgan (20) und der zweite Federschachtkörper (14) mindestens ein Langloch (22) für das federnde Rastorgan (20) aufweist.

2. Anschlusseinrichtung nach Anspruch 1,
**dadurch gekennzeichnet,**
**dass** das erste Kontaktteil (42) der Kontaktfeder (18) dem ersten Federschachtkörper (12) und das zweite Kontaktteil (38) der Kontaktfeder (18) dem zweiten Federschachtkörper (14) zugeordnet ist.

3. Anschlusseinrichtung nach Anspruch 1,
**dadurch gekennzeichnet,**
**dass** der erste und der zweite Federschachtkörper (12, 14) gegen Verdrehung gesichert sind.

4. Anschlusseinrichtung nach Anspruch 1,
**dadurch gekennzeichnet,**
**dass** der erste Federschachtkörper (12) eine an einer Anschlag-Öffnung (58) im Gehäuse (60) anliegende Anlageschulter (26) aufweist.

5. Anschlusseinrichtung nach Anspruch 1,
**dadurch gekennzeichnet,**
**dass** der zweite Federschachtkörper (14) einen Widerlagerbund (28) für den Druckkörper (32) aufweist.

6. Anschlusseinrichtung nach Anspruch 1,
**dadurch gekennzeichnet,**
**dass** der zweite Federschachtkörper (14) im Druckkörper (32) verdrehfest vorgesehen ist.

7. Anschlusseinrichtung nach Anspruch 1,
**dadurch gekennzeichnet,**
**dass** der zweite Federschachtkörper (14) mit einem Kappenabschnitt (52) aus dem Druckkörper (14) vorsteht.

8. Anschlusseinrichtung nach Anspruch 7,
**dadurch gekennzeichnet,**
**dass** der Kappenabschnitt (52) des zweiten Federschachtkörpers (14) oberseitig mit einem Querschlitz (56) ausgebildet ist, aus dem das zweite Kontaktteil (38) der Kontaktfeder (18) U-förmig gebogen vorsteht.

9. Anschlusseinrichtung nach Anspruch 1,
**dadurch gekennzeichnet,**
**dass** der erste Federschachtkörper (12) unterseitig ein Durchgangsloch (44) für das erste Kontaktteil (42) der Kontaktfeder (18) aufweist, das stiftförmig ausgebildet ist.

10. Anschlusseinrichtung nach einem der vorhergehenden Ansprüche,
**dadurch gekennzeichnet,**
**dass** der erste und der zweite Federschachtkörper (12, 14) des Federschachtes (16) aus einem nicht korrodierenden Kunststoffmaterial bestehen.

11. Anschlusseinrichtung nach einem der vorhergehenden Ansprüche, wobei mindestens zwei Federschächte (16) mit den zugehörigen Kontaktfedern (18) integral zu einem Federschachtblock (62) kombiniert sind.

## Claims

1. A connection device for a power semiconductor module (34), which has a housing (60) for at least one circuit substrate (48) and a compression body (32) for purposes of applying a contact pressure to a connection element, which is designed as a contact spring (18) with a first contact part (42) and a second contact part (38) and a sprung section (50) between the first and second contact parts (42, 38),
**characterised in that**,
the connection device (10) has a first sprung shaft body (12) assigned to the housing (60) and a second sprung shaft body (14) assigned to the compression body (32), which are connected with one another in an axially aligned manner to form a sprung shaft (16), and can move relative to one another in an axially limited manner, wherein
the sprung shaft (16) can be preassembled independently of the housing (60) and the compression body (32), wherein
the contact spring (18) is captively provided in the sprung shaft (16), wherein
the first sprung shaft body (12) has at least one sprung latching element (20) and the second sprung shaft body (14) has at least one elongated hole (22) for the sprung latching element (20).

2. The connection device in accordance with Claim 1,
**characterised in that**,
the first contact part (42) of the contact spring (18) is assigned to the first sprung shaft body (12) and the second contact part (38) of the contact spring (18) is assigned to the second sprung shaft body (14).

3. The connection device in accordance with Claim 1,
**characterised in that**,
the first and second sprung shaft bodies (12, 14) are secured against rotation.

4. The connection device in accordance with Claim 1,
**characterised in that**,
the first sprung shaft body (12) has a seating shoulder (26) abutting against a stop opening (58) in the housing (60) .

5. The connection device in accordance with Claim 1,
**characterised in that**,
the second sprung shaft body (14) has an abutment collar (28) for the compression body (32).

6. The connection device in accordance with Claim 1,
**characterised in that**,
the second sprung shaft body (14) is provided such that it cannot rotate in the compression body (32).

7. The connection device in accordance with Claim 1,
**characterised in that**,
the second sprung shaft body (14) with a cap section (52) projects out of the compression body (14).

8. The connection device in accordance with Claim 7,
**characterised in that**,
the cap section (52) of the second sprung shaft body (14) is designed on the upper face with a transverse slot (56), out of which projects the second contact part (38) of the contact spring (18), curved in a U-shape.

9. The connection device in accordance with Claim 1,
**characterised in that**,
the first sprung shaft body (12) has on its lower face a passage hole (44) for the first contact part (42) of the contact spring (18), which is designed in the form of a pin.

10. The connection device in accordance with one of the preceding claims,
**characterised in that**,
the first and second sprung shaft bodies (12, 14) of the sprung shaft (16) consist of a non-corroding plastic material.

11. The connection device in accordance with one of the preceding claims, wherein
at least two sprung shafts (16) with the related contact springs (18) are integrally combined to form a sprung shaft block (62).

## Revendications

1. Dispositif de connexion pour un module semi-conducteur de puissance (34) comportant un boîtier (60) pour au moins un substrat de circuit (48) et un corps de pression (32) pour le contact par pression d'un élément de connexion réalisé comme ressort de contact (18) avec une première pièce de contact (42) et une deuxième pièce de contact (38) et un segment de ressort (50) entre la première et la deuxième pièce de contact (42, 38), **caractérisé en ce que**
ledit dispositif de connexion (10) comporte un premier corps de gaine de ressort (12) associé au boîtier (60) et un deuxième corps de gaine de ressort (14) attribué au corps de pression (32), lesquels sont reliés axialement entre eux en étant alignés avec une gaine de ressort (16) et sont mobiles de manière axialement limitée l'un par rapport à l'autre, la gaine de ressort (16) pouvant être pré-montée indépendamment du boîtier (60) et du corps de pression (32), le ressort de contact (18) étant prévu imperdable dans la gaine de ressort (16), le premier corps de gaine de ressort (12) comportant au moins un élément d'enclenchement élastique (20) et le deuxième corps de gaine de ressort (14) au moins un trou oblong (22) pour l'élément d'enclenchement élastique (20).

2. Dispositif de connexion selon la revendication 1, **caractérisé en ce que**
la première pièce de contact (42) du ressort de contact (18) est associée au premier corps de gaine de ressort (12), et la deuxième pièce de contact (38) du ressort de contact (18) au deuxième corps de gaine de ressort (14).

3. Dispositif de connexion selon la revendication 1, **caractérisé en ce que**
une rotation du premier et du deuxième corps de gaine de ressort (12, 14) est empêchée.

4. Dispositif de connexion selon la revendication 1, **caractérisé en ce que**
le premier corps de gaine de ressort (12) comporte un épaulement d'appui (26) reposant contre une ouverture d'appui (58) du boîtier (60).

5. Dispositif de connexion selon la revendication 1, **caractérisé en ce que**
le deuxième corps de gaine de ressort (14) comporte un épaulement de butée (28) pour le corps de pression (32).

6. Dispositif de connexion selon la revendication 1, **caractérisé en ce que**
le deuxième corps de gaine de ressort (14) est prévu non rotatif dans le corps de pression (32).

7. Dispositif de connexion selon la revendication 1, **caractérisé en ce que**
le deuxième corps de gaine de ressort (14) dépasse par une partie en capuchon (52) du corps de pression (14).

8. Dispositif de connexion selon la revendication 7, **caractérisé en ce que**
sur sa partie supérieure, la partie en capuchon (52) du deuxième corps de gaine de ressort (14) est réalisée avec une fente transversale (56) d'où la deuxième pièce de contact (38) du ressort de contact (18) fait saillie, pliée en U.

9. Dispositif de connexion selon la revendication 1, **caractérisé en ce que**
sur sa partie inférieure, le premier corps de gaine de ressort (12) présente un trou débouchant (44) pour la première pièce de contact (42) du ressort de contact (18), laquelle est réalisée en forme de broche.

10. Dispositif de connexion selon l'une des revendications précédentes, **caractérisé en ce que**
le premier et le deuxième corps de gaine de ressort (12, 14) de la gaine de ressort (16) sont composés d'une matière plastique non corrosive.

11. Dispositif de connexion selon l'une des revendications précédentes, où au moins deux gaines de ressort (16) sont combinées avec les ressorts de contact (18) correspondants pour former un bloc de gaine de ressort (62) intégré.
